# EUROPEAN PATENT SPECIFICATION

(11) **EP 0 730 309 B1**
(45) Date of publication and mention of the grant of the patent: **14.10.1998**
(21) Application number: 95830045.1
(22) Date of filing: 21.02.1995
(51) Int. Cl.: H01L 29/78, H01L 29/06, H01L 29/08, H01L 21/336

(54) **A high voltage MOSFET structure with field plate electrode and process for its fabrication**
Hochspannungs-MOSFET mit Feldplatten-Elektrode und Verfahren zur Herstellung
MOSFET haute tension avec électrode de plaque de champ et méthode de fabrication

(43) Date of publication of application: 04.09.1996
(73) Proprietor: STMicroelectronics S.r.l., 20041 Agrate Brianza (Milano) (IT)
(72) Inventor: De Petro, Riccardo, I-28037 Domodossola, Novara (IT); Palmieri, Michele, I-70100 Bitonto, Bari (IT); Galbiati, Paola, I-20052 Monza, Milano (IT); Contiero, Claudio, I-20090 Buccinasco, Milano (IT)
(74) Representative: Maggioni, Claudio

(56) References cited:
- EP-A- 0 098 652
- EP-A- 0 294 888
- EP-A- 0 487 022
- DE-A- 3 816 002
- PATENT ABSTRACTS OF JAPAN vol. 11, no. 99 (E-493) 27 March 1987 & JP-A-61 248 565 (MITSUBISHI ELECTRIC CORP) 05 November 1986

## Description

The present invention relates to semiconductor devices and more particularly to a high voltage MOSFET transistor structure as is defined in the preamble of Claim 1, and a process for making a structure of this type.

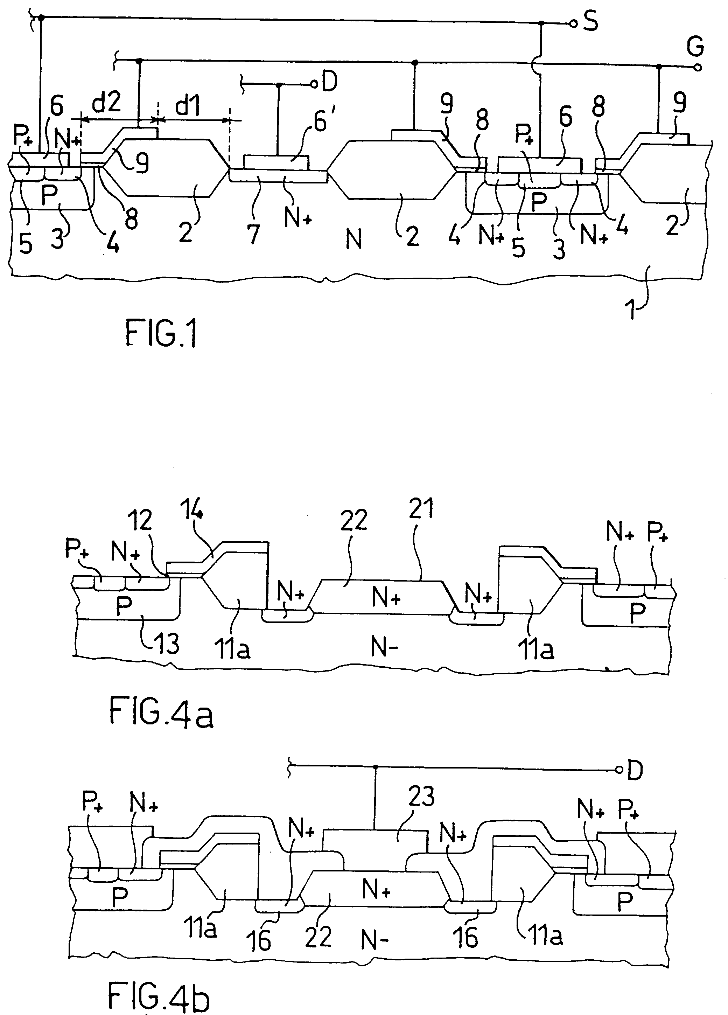

Many complex integrated circuits make use of lateral double diffused MOSFET transistors capable of supporting relatively high voltages (40-60V) (LDMOS: lateral double diffused metal oxide semiconductor) both of N channel and P channel type, and P channel vertical MOSFET transistors, again for relatively high voltages. By way of example, Figure 1 of the attached drawings shows a schematic partial section of an N channel LDMOS transistor structure. This transistor is formed on an epitaxial layer of N type, indicated 1, formed, in turn, on a P type monocrystalline silicon substrate, not shown, and has an interdigitated geometry, that is to say it is composed of interpenetrating modular functional elements. In the drawing there are shown two source elements and one drain element with their associated gate electrodes.

More particularly, the structure of Figure 1 comprises insulating elements 2 in the form of patches of relatively thick silicon dioxide, for example 1µm, the so called field oxide, obtained by a known insulating technique by selective oxidation of the silicon with a silicon nitride mask. The insulating elements 2 separate silicon surfaces between them, the so-called active areas. In alternate active areas are formed P type regions indicated 3, the so-called "body" regions of the transistor, within which are formed respective source regions of strongly doped N type (N+), indicated 4.

The source regions 4 are traversed by strongly doped P type regions (P+) indicated 5, which serve to contact the body regions 3.

Suitable metal strips, indicated 6, in ohmic contact with the regions 4 and 5 are joined together to form the source terminal S of the transistor.

In the active areas between each two source elements the epitaxial layer 1 is locally enriched with N type doping material in such a way as to form strongly doped N type regions (N+) indicated 7, which together with the zones of the epitaxial layer 1 adjacent to it, constitute the elementary drain regions.

Metal strips are also formed on these regions, only one of which is visible in Figure 1 indicated 6', in ohmic contact and joined together to form the drain terminal D of the transistor.

The edge zones of the body regions 3, which constitute the channel zones of the transistor, are overlain by relatively thin layers (for example 0.2 µm) of silicon dioxide, indicated 8. Over these layers and over edge portions of the insulating elements of field oxide 2 are formed layers of electroconductive material, for example doped polycrystalline silicon, indicated 9, which are joined together to form the gate electrode G of the transistor.

The strips 9 also fulfil the function of field plates for the drain junctions, that is to say for the junctions between the body regions 3 and the drain regions 7, 1. In the operation of the transistor these junctions are reverse biased and the field plate is normally at a potential, with respect to that of the drain, which has the effect of reducing the electric field of the junction in proximity to the silicon surface and thus of increasing the maximum breakdown voltage between source and drain of the transistor.

A field-effect transistor having a structure similar to the structure described above is known from EP-A-0 294 888 which discloses a prior art device according to the preamble of claim 1. Furthermore, a field-effect transistor with a gate electrode completely overlying a thick oxide layer is known from JP-A-61248565.

In order to reduce both the area occupied by the transistor and the series resistance of the transistor in direct conduction it is sought to reduce as much as possible the width of the insulating elements of field oxide 2. The minimum width of these elements is, however, set by various fabrication requirements. In particular, the minimum distance between the edge of the strip 9 and the extremity of the field oxide 2 closest to the drain region 7, indicated dl in Figure 1, is determined by the maximum possible alignment error with the photolithographic technique utilised and the minimum distance, indicated d2, between the same edge and the other extremity of the field oxide 2 is determined both by the contact dimensions of the gate electrode, which must be formed on the side of the strip 9 overlying the field oxide, and by the maximum breakdown voltage which it is wished to obtain.

The object of the present invention is to provide a high voltage MOSFET transistor structure as is defined in the preamble of Claim 1, which occupies a smaller area than that occupied by known structures, and a process for the fabrication of such a structure.

This object is achieved according to the invention with a structure as defined in general in Claim 1 and with a process as defined in general in Claim 5.

The invention will be better understood from the following detailed description of an exemplary and therefore in no way limitative example in relation to the attached drawings, in which:
Figure 1, already described, is a partial section of a known N channel LDMOS transistor;
Figures 2a - 2d are partial sections of a LDMOS transistor structure according to the invention in various stages of fabrication;
Figure 3 is a partial plan view of a structure according to the invention, constituted by a plurality of modular elements, in a fabrication stage immediately preceding that of Figure 2d;
Figure 4a is a partial section of the structure according to the invention taken on the line IV-IV of Figure 3; and
Figure 4b is a partial section of the structure according to the invention in a subsequent stage to that shown in Figure 4a.

The principal steps of the process for the formation of a transistor structure according to the invention are described hereinbelow with reference to the drawings.

It is pointed out that the concentrations of N type and P type impurities in the various regions are indicated, as usual, by adding the minus sign or plus sign to the letters N and P; the letters N and P without the addition of a minus or plus sign denote concentrations of intermediate value.

A layer of (N-) monocrystalline silicon is formed, by epitaxial growing at high temperature, on a P type monocrystalline silicon substrate, not shown.

This layer is subdivided, by means of (P+) diffused regions, which extend in depth down to the substrate, not shown, in a multiplicity of portions, usually called "wells", insulated from one another, within which will be formed electronic components of various type, such as MOS power and signal transistors, bipolar power and signal transistors, diodes, memories etc.

Relatively thick patches of silicon dioxide are formed by selective oxidation at high temperature with a silicon nitride mask to isolate different regions superficially within a well. The field oxide thus formed grows at the expense of the underlying silicon so that the internal surfaces of the patches are sunken with respect to the original surface of the epitaxial layer. A portion of one such well, intended to contain a high voltage lateral MOSFET transistor according to the invention is indicated 10 in the drawings.

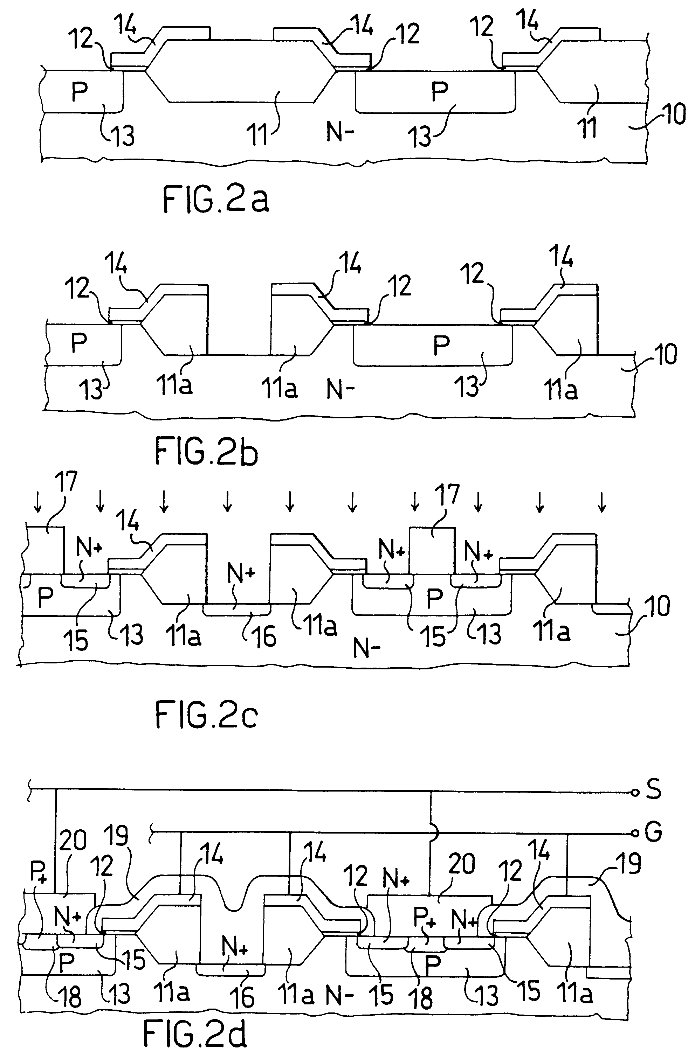

With reference particularly to Figure 2a, two patches of field oxide 11 delimit active areas between them. These are covered by a thin layer of silicon dioxide, obtained by oxidation at high temperature of the silicon of the epitaxial layer 10. In the active areas are formed P regions, indicated 13, intended to be the "body" regions of the transistor, which are formed by deposition and diffusion of a P type doping material, for example boron by utilising a polycrystalline silicon layer as a mask, preliminarily deposited over the whole surface of the structure in formation and then removed from the areas to be doped.

Before deposition of the doping material the thin oxide layer is removed from the same areas and therefore remains only under the layer of polycrystaline silicon.

The residual thin oxide, indicated 12, and the overlying residual polycrystalline silicon in the form of strip 14, are intended to constitute, respectively, the gate dielectric and the gate electrode of the transistor.

The polycrystalline silicon is rendered conductive by doping during the subsequent working steps.

As is shown in Figure 2a, the strips of polycrystalline silicon delimit apertures on the field oxide 11.

The subsequent operation consists in an anisotropic etching of the field oxide through the apertures of the polycrystalline silicon layer.

Preferably, this etching is effected by CF₄/CHF₃/Ar plasma at a pressure of 23.3 Pa (175mTorr) and with a radio frequency power of 700 watt.

This etching has a high selectivity with respect to the silicon, that is to say a much greater speed of attack on the silicon dioxide than that on the silicon, both polycrystalline and monocrystalline. There is thus obtained the structure represented in Figure 2b, in which it is seen that the patch 11 has been divided into two parts 11a which constitute two separate insulating elements.

The surface of the structure under formation is then subjected to ionic implantation, indicated with arrows in Figure 2c, with an N-type doping material, for example arsenic, after having masked the central parts of the surfaces of the P-body regions 13 with a photoresist 17.

During a subsequent heating step two (N+) regions are formed of which those indicated 15, which form in the body regions, are intended together to form the source region of the transistor and those, indicated 16, which constitute a local enrichment of the doping of the epitaxial layer 10, are intended together to form the drain region of the transistor. More precisely, the drain region also extends in part into the epitaxial layer laterally of the (N+ ) enriched regions 16 up to the P-body regions. The drain junction is in fact formed between the body regions 13 and the epitaxial layer 10.

As is seen, the strips of polycrystalline silicon 14, the insulating elements 11a and the enriched drain regions 16 have substantially aligned edges. Moreover, the mask formed by the strips of the polycrystalline silicon 14 allow automatic alignment both of the source regions 15 and the enriched drain regions 16, with the advantage of a great compactness of the structure and a high uniformity of the electrical characteristics of the modular elements forming the transistor.

After removal of the photoresist mask 17 known techniques are used to form (P+) regions, indicated 18 in Figure 2d which regions serve to contact the body regions 13; to deposit a layer of passivating and insulating silicon dioxide 19; to open windows in this layer 19 for the formation of metal interconnections, for example of aluminium; to connect the source regions electrically together and to the source terminal S, the drain regions together and to the drain terminal D, and the gate electrodes together and to the gate terminal G of the transistor. In Figure 2d only the metal source interconnection tracks indicated 20, can be seen, in ohmic contact with the regions 15 and 18. The interconnection tracks of the source elements are represented by schematic electrical connection lines, as also are the gate interconnection tracks.

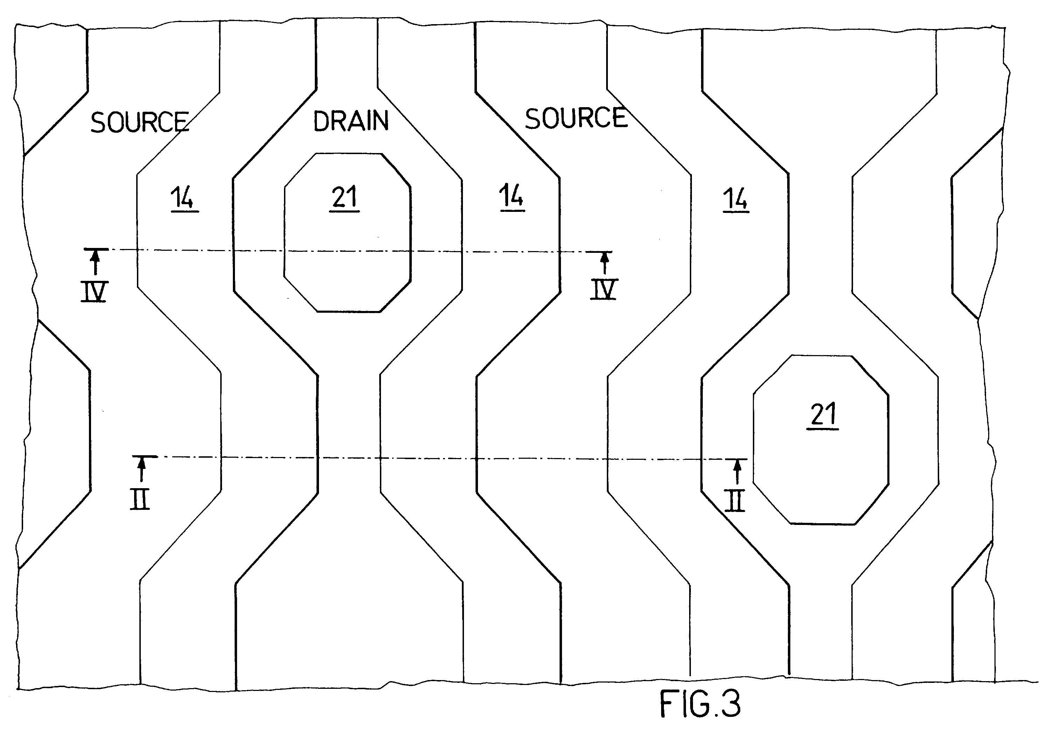

As far as the drain interconnections and contacts are concerned, the plan view of Figure 3 and the section views of Figures 4a and 4b are now considered. In Figure 3 the lines II-II and IV-IV indicate two section lines of the structure in the fabrication stage immediately preceding that of deposition of the passivation layer 19.

As is seen in Figure 4b, which represents the structure according to the invention in the fabrication stage of Figure 2d, the drain contact of each transistor element occupies an active area, indicated 21 in Figures 3, 4a and 4b, from which the original insulation of field oxide has been removed in the selective and anisotropic etching step described above, and strongly doped with an N-type doping in such a way as to form an (N+) region indicated 22 in Figures 4a and 4b in contact with the (N+) regions 16.

A metal track 23 in ohmic contact with the (N+) region 22 forms the drain terminal of the transistor element and is connected to the other elements to constitute the drain terminal D.

From a comparison with the known structure of Figure 1 it can easily be established that the high voltage lateral -MOSFET transistor structure according to the invention occupies a very much smaller area in that the (N+) enriched drain regions 16 do not require a specially provided active area as in the case of the known structure, and the field oxide portions which in the prior art extended for a distance d1 over both the sides of the (N+) enriched regions 7 are entirely missing in the new structure. In practice the saving of area can be up to 40%.

It is important to observe in this connection that the reduction of the dimensions of the field oxide not only does not compromise the voltage barrier between source and drain, but involves significant advantages in terms of electrical characteristics of the transistor.

More particularly, as has already been mentioned, it has been established that the field plate function performed by the polycrystalline silicon strips 14 as well as that of the gate electrode remain unaltered because they do not depend on the lateral extent of the field oxide but only on the distance between the edge of the part overlying the field oxide from the edge of the (N+) enriched drain region. This distance, according to the invention, is not reduced because the thickness of the field oxide is normally at least equal to the lateral dimension d1 which, as has already been mentioned, was set only by the photolithographic tolerances. This result, in the example described, is also encouraged by the fact that, with the insulating technique by means of selective oxidation of the silicon with a silicon nitride mask, the (N+) enriched regions 16 extend from a lower level than the surface of the epitaxial layer 10.

As far as the electrical characteristics of the transistor are concerned, then, the dimensional reduction involves a considerable shortening of the path of the drain current in the epitaxial layer 10, which has a relatively high resistivity, and therefore a reduction in the resistance between source and drain per unit area with the transistor in direct conduction (specific resistance RDS on).

Although only a single embodiment of the invention has been illustrated and described, it is clear that numerous variations and modifications are possible within the ambit of the same inventive concept. For example, with the process according to the invention a structure can be achieved entirely similar to that described for obtaining a P channel rather than an N channel lateral MOSFET transistor or to obtain a P channel vertical MOSFET transistor.

## Claims

1. A high voltage MOSFET transistor structure on a layer of monocrystalline silicon (10) which is formed on a silicon substrate and has a front surface, said transistor structure being constituted by at least a pair of modular functional elements, each modular functional element comprising
- a first region (15) and a second region (16, 10) of the same conductivity type formed in the silicon layer (10) and delimited by the front surface thereof, respectively serving as source region and drain region, separated by a region (13) of opposite conductivity which comprises a channel zone delimited by the front surface of the silicon layer (10), the second region (16, 10) forming with this region (13) of opposite conductivity a junction delimited by said front surface and including an enriched region (16) delimited by the same front surface, said enriched region (16) being common to both modular functional elements of the pair,
- a relatively thick insulating element (11a) of silicon dioxide formed on the front surface of the layer (10) and extending between the channel zone and the enriched region (16),
- a relatively thin strip of silicon dioxide (12) formed on the front surface over the channel zone serving as gate dielectric,
- a strip of electroconductive material (14) which extends over the relatively thin strip of silicon dioxide (12) and over the relatively thick insulating element of silicon dioxide (11a) serving as a gate electrode and as a field plate for said junction, and
- electrical connection means (20, 22, 23) to the first region (15), to the enriched region (16) and to the strip of electroconductive material (14) for forming, respectively, the source terminal (S), drain terminal (D) and gate terminal (G) of the transistor,
characterised in that the strip of electroconductive material (14) completely overlies the relatively thick insulating element of silicon dioxide (lla) and the strip of electroconductive material (14), the insulating element (11a) and the enriched region (16) have edges which are substantially aligned with one another.

2. A structure according to Claim 1, wherein the relatively thick insulating element (11a) of silicon dioxide is located on a sunken part of the front surface and the enriched region (16) is formed in this sunken part of the front surface.

3. A structure according to Claim 1 or Claim 2, comprising a multiplicity of interdigitated modular functional elements connected electrically together.

4. A structure according to Claim 2 or Claim 3, wherein the means for electrical connection with the enriched region (16) includes a strongly doped interconnection region (22) of the same conductivity type which is in contact with the enriched region (16) and is delimited by a non-sunken portion of the front surface.

5. A process for the fabrication of a high voltage MOSFET transistor on a layer (10) of monocrystalline silicon which is formed on a silicon substrate and has a front surface, comprising the operations of:
- forming in the silicon layer (10) a first region (15) and a second region (16, 10) of the same conductivity type delimited by the front surface of the silicon layer (10) and serving, respectively, as source region and drain region separated by a region (13) of opposite conductivity which comprises a channel zone delimited by the front surface of the silicon layer (10), the second region (16, 10) forming with this region (13) of opposite conductivity a junction delimited by said front surface,
- forming in said second region (16, 10) an enriched region (16) delimited by the front surface,
- forming a relatively thick insulating element (11A) of silicon dioxide on the front surface of the silicon layer (10) and extending between the channel zone and the enriched region (16)
- forming a relatively thin strip (12) of silicon dioxide on the front surface over the channel zone serving as a gate dielectric,
- forming a strip (14) of electroconductive material over the relatively thin strip (12) of silicon dioxide and over the relatively thick insulating element (11A) of silicon dioxide, serving as a gate electrode and as a field plate for said junction, and
- forming electrical connection means (20, 22, 23) with the first region (15), the enriched region (16) and the strip of electroconductive material (14) to form, respectively, the source terminal (S), drain terminal (D) and gate terminal (G) of the transistor, characterised in that the formation of the relatively thick insulating element (11A) of silicon dioxide comprises the following operations
- forming a patch (11) of relatively thick silicon dioxide over the front surface of the silicon layer (10),
- forming a layer of electroconductive material which extends at least over the patch (11),
- selectively removing the layer of electroconductive material in such a way as to expose a part of the patch (11) and to obtain the said strip (14) to form the gate electrode and field plate and
- performing a selective anisotropic etching of the silicon dioxide of the patch (11) utilising the layer of electroconductive material as a mask to expose an area of the front surface of the silicon layer (10) and in that the formation of the enriched region (16) includes the introduction of doping material into the silicon layer (10) through the area of the front surface exposed with the said selective anisotropic etching.

6. A process according to Claim 5 in which the formation of a patch (11) of relatively thick silicon dioxide (11) takes place by selective oxidation at high temperature with a mask of silicon nitride.

## Patentansprüche

1. Eine Hochspannungs-MOSFET-Transistorstruktur auf einer Schicht aus monokristallinem Silizium (10), die auf einem Siliziumsubstrat gebildet ist und eine vordere Oberfläche aufweist, wobei die Transistorstruktur durch zumindest ein Paar von modularen funktionellen Elementen gebildet ist, wobei jedes modulare funktionelle Element folgende Merkmale aufweist:
- eine erste Region (15) und eine zweite Region (16, 10) des gleichen Leitfähigkeitstyps, die in der Siliziumschicht (10) gebildet sind und durch die vordere Oberfläche derselben begrenzt sind, welche jeweils als Source-Region und Drain-Region dienen, die durch eine Region (13) einer entgegengesetzten Leitfähigkeit getrennt sind, die eine Kanalzone aufweist, die durch die vordere Oberfläche der Siliziumschicht (10) begrenzt ist, wobei die zweite Region (16, 10) mit dieser Region (13) einer entgegengesetzten Leitfähigkeit einen Übergang bildet, der durch die vordere Oberfläche begrenzt ist, und eine angereicherte Region (16) enthält, die durch die gleiche vordere Oberfläche begrenzt ist, wobei die angereicherte Region (16) beiden modularen funktionellen Elementen des Paars gemeinsam ist,
- ein relativ dickes isolierendes Element (11a) aus Siliziumdioxid, das auf der vorderen Oberfläche der Schicht (10) gebildet ist und sich zwischen der Kanalzone und der angereicherten Region (16) erstreckt,
- einen relativ dünnen Streifen aus Siliziumdioxid (12), der über der Kanalzone auf der vorderen Oberfläche gebildet ist und als Gate-Dielektrikum dient,
- einem Streifen aus einem elektrisch leitfähigen Material (14), der sich über den relativ dünnen Streifen aus Siliziumdioxid (12) und über das relativ dicke isolierende Element aus Siliziumdioxid (lla) erstreckt und der als eine Gate-Elektrode und als eine Feldplatte für den Übergang dient, und
- eine elektrische Verbindungseinrichtung (20, 22, 23) zu der ersten Region (15), zu der angereicherten Region (16) und zu dem Streifen aus dem elektrisch leitfähigen Material (14), um den Source-Anschluß (S), den Drain-Anschluß (D) bzw. den Gate-Anschluß (G) des Transistors zu bilden,
dadurch gekennzeichnet, daß der Streifen aus einem elektrisch leitfähigen Material (14) das relativ dicke isolierende Element aus Siliziumdioxid (11a) vollständig überlagert, und daß der Streifen aus dem elektrisch leitfähigen Material (14), das isolierende Element (11a) und die angereicherte Region (16) Ränder aufweisen, die im wesentlichen miteinander ausgerichtet sind.

2. Eine Struktur gemäß Anspruch 1, bei der das relativ dicke isolierende Element (11a) aus Siliziumdioxid auf einem versenkten Teil der vorderen Oberfläche angeordnet ist, und bei der die angereicherte Region (16) in diesem versenkten Teil der vorderen Oberfläche gebildet ist.

3. Eine Struktur gemäß Anspruch 1 oder Anspruch 2, die eine Vielzahl von interdigital angeordneten modularen funktionellen Elementen aufweist, die elektrisch miteinander verbunden sind.

4. Eine Struktur gemäß Anspruch 2 oder Anspruch 3, bei der die Einrichtung zur elektrischen Verbindung mit der angereicherten Region (16) eine stark dotierte Zwischenverbindungsregion (22) des gleichen Leitfähigkeitstyps aufweist, die in Kontakt mit der angereicherten Region (16) ist und durch einen nicht-versenkten Abschnitt der vorderen Oberfläche begrenzt ist.

5. Ein Verfahren zur Herstellung eines Hochspannungs-MOSFET-Transistors auf einer Schicht (10) aus monokristallinem Silizium, die auf einem Siliziumsubstrat gebildet ist und eine vordere Oberfläche aufweist, mit folgenden Schritten:
- Bilden einer ersten Region (15) und einer zweiten Region (16, 10) des gleichen Leitfähigkeitstyps, die durch die vordere Oberfläche der Siliziumschicht (10) begrenzt sind und als eine Source-Region bzw. eine Drain-Region dienen, die durch eine Region (13) einer entgegengesetzten Leitfähigkeit, die eine Kanalzone aufweist, die durch die vordere Oberfläche der Siliziumschicht (10) begrenzt ist, getrennt sind, in der Siliziumschicht (10), wobei die zweite Region (16, 10) mit dieser Region (13) einer entgegengesetzten Leitfähigkeit einen Übergang bildet, der durch die vordere Oberfläche begrenzt ist,
- Bilden einer angereicherten Region (16), die durch die vordere Oberfläche begrenzt ist, in der zweiten Region (16, 10),
- Bilden eines relativ dicken isolierenden Elements (lla) aus Siliziumdioxid auf der vorderen Oberfläche der Siliziumschicht (10), die sich zwischen der Kanalzone und der angereicherten Region (16) erstreckt,
- Bilden eines relativ dünnen Streifens (12) aus Siliziumdioxid auf der vorderen Oberfläche über der Kanalzone, der als Gate-Dielektrikum dient,
- Bilden eines Streifen (14) aus einem elektrisch leitfähigen Material über dem relativ dünnen Streifen (12) aus Siliziumdioxid und über dem relativ dicken isolierenden Element (11a) aus Siliziumdioxid, der als eine Gate-Elektrode und als eine Feldplatte für den Übergang dient, und
- Bilden einer elektrischen Verbindungseinrichtung (20, 22, 23) mit der ersten Region (15), der angereicherten Region (16) und dem Streifen aus einem elektrisch leitfähigen Material (14), um den Source-Anschluß (S), den Drain-Anschluß (D) bzw. den Gate-Anschluß (G) des Transistors zu bilden, dadurch gekennzeichnet, daß die Bildung des relativ dicken isolierenden Elements (lla) aus Siliziumdioxid folgende Schritte aufweist:
- Bilden eines Fleckens (11) aus einem relativ dicken Siliziumdioxid über der vorderen Oberfläche der Siliziumschicht (10),
- Bilden einer Schicht aus einem elektrisch leitfähigen Material, die sich zumindest über dem Flecken (11) erstreckt,
- selektives Beseitigen der Schicht aus dem elektrisch leitfähigen Material auf eine Art und Weise, um einen Teil des Fleckens (11) freizulegen, und um den Streifen (14) zu erhalten, um die Gate-Elektrode und die Feldplatte zu bilden, und
- Durchführen eines selektiven anisotropen Ätzens des Siliziumdioxids des Fleckens (11) unter Verwendung der Schicht aus dem elektrisch leitfähigen Material als eine Maske, um einen Bereich der vorderen Oberfläche der Siliziumschicht (10) freizulegen und ferner dadurch gekennzeichnet, daß das Bilden der angereicherten Region (16) das Einbringen eines Dotierungsmaterials in die Siliziumschicht (10) durch den Bereich der vorderen Oberfläche, der mittels des selektiven anisotropen Ätzens freigelegt wurde, umfaßt.

6. Ein Verfahren gemäß Anspruch 5, bei dem die Bildung eines Fleckens (11) aus einem relativ dicken Siliziumdioxid (11) durch eine selektive Oxidation bei einer hohen Temperatur mit einer Maske aus Siliziumnitrid stattfindet.

## Revendications

1. Structure de transistor MOSFET à tension élevée sur une couche de silicium monocristallin (10) qui est formée sur un substrat de silicium et a une surface avant, ladite structure de transistor étant constituée d'au moins une paire d'éléments fonctionnels modulaires, chaque élément fonctionnel modulaire comprenant:
- une première région (15) et une deuxième région (16, 10) de même type de conductivité formées dans la couche de silicium (10) et délimitées par la surface avant de celle-ci, servant respectivement de région de source et de région de drain, séparées par une région (13) de conductivité opposée qui comprend une zone de canal délimitée par la surface avant de la couche de silicium (10), la deuxième région (16, 10) formant avec cette région (13) de conductivité opposée une jonction délimitée par ladite surface avant et comprenant une région enrichie (16) délimitée par la même surface avant, ladite région enrichie (16) étant commune à deux éléments fonctionnels modulaires de la paire,
- un élément isolant relativement épais (11a) de dioxyde de silicium formé sur la surface avant de la couche (10) et s'étendant entre la zone de canal et la région enrichie (16),
- un ruban relativement mince de dioxyde de silicium (12) formé sur la surface avant au-dessus de la zone de canal servant de diélectrique de porte,
- un ruban de matériau électroconducteur (14) qui s'étend au-dessus du ruban relativement mince de dioxyde de silicium (12) et au-dessus de l'élément isolant relativement épais de dioxyde de silicium (11a) servant d'électrode de porte et de plaque de champ à ladite jonction, et
- des moyens de connexion électrique (20, 22, 23) à la première région (15), à la région enrichie (16) et au ruban de matériau électroconducteur (14) pour former, respectivement, la borne de source (S), la borne de drain (D) et la borne de porte (G) du transistor,
caractérisée en ce que le ruban de matériau électroconducteur (14) recouvre complètement l'élément isolant relativement épais de dioxyde de silicium (11a), et le ruban de matériau électroconducteur (14), l'élément isolant (11a) et la région enrichie (16) ont des bords qui sont sensiblement alignés entre eux.

2. Structure selon la revendication 1, dans laquelle l'élément isolant relativement épais (11a) de dioxyde de silicium est situé sur une partie renfoncée de la surface avant, et la région enrichie (16) est formée dans cette partie renfoncée de la surface avant.

3. Structure selon la revendication 1 ou la revendication 2, comprenant une multiplicité d'éléments fonctionnels modulaires interdigités connectés électriquement ensemble.

4. Structure selon la revendication 2 ou la revendication 3, dans laquelle les moyens de connexion électrique avec la région enrichie (16) comprennent une région d'interconnexion fortement dopée (22) de même type de conductivité qui est en contact avec la région enrichie (16) et est délimitée par une portion non renfoncée de la surface avant.

5. Procédé de fabrication d'un transistor MOSFET à tension élevée sur une couche (10) de silicium monocristallin qui est formée sur un substrat de silicium et a une surface avant, comprenant les opérations consistant à:
- former dans la couche de silicium (10) une première région (15) et une deuxième région (16, 10) de même type de conductivité, délimitées par la surface avant de la couche de silicium (10) et servant, respectivement, de région de source et de région de drain, séparées par une région (13) de conductivité opposée qui comprend une zone de canal délimitée par la surface avant de la couche de silicium (10), la deuxième région (16, 10) formant avec cette région (13) de conductivité opposée une jonction délimitée par ladite surface avant,
- former dans ladite deuxième région (16, 10) une région enrichie (16) délimitée par la surface avant,
- former un élément isolant relativement épais (11a) de dioxyde de silicium sur la surface avant de la couche de silicium (10) et s'étendant entre la zone de canal et la région enrichie (16),
- former un ruban relativement mince (12) de dioxyde de silicium sur la surface avant au-dessus de la zone de canal, servant de diélectrique de porte,
- former un ruban (14) de matériau électroconducteur au-dessus du ruban relativement mince (12) de dioxyde de silicium et au-dessus de l'élément isolant relativement épais (11a) de dioxyde de silicium, servant d'électrode de porte et de plaque de champ pour ladite jonction, et
- former des moyens de connexion électrique (20, 22, 23) avec la première région (15), la région enrichie (16) et le ruban de matériau électroconducteur (14) de manière à former, respectivement, la borne de source (S), la borne de drain (D) et la borne de porte (G) du transistor,
caractérisé en ce que la formation de l'élément isolant relativement épais (lla) de dioxyde de silicium comprend les opérations suivantes consistant à:
- former une bande (11) relativement épaisse de dioxyde de silicium au-dessus de la surface avant de la couche de silicium (10),
- former une couche de matériau électroconducteur qui s'étend au moins sur la bande (11),
- supprimer sélectivement la couche de matériau électroconducteur de manière à exposer une partie de la bande (11) et à obtenir ledit ruban (14) pour former l'électrode de porte et la plaque de champ, et
- accomplir un décapage anisotrope sélectif du dioxyde de silicium de la bande (11) en utilisant la couche de matériau électroconducteur en tant que masque afin d'exposer une aire de la surface avant de la couche de silicium (10), et en ce que la formation de la région enrichie (16) comprend l'introduction d'un matériau de dopage dans la couche de silicium (10) par l'aire de la surface avant exposée à l'aide dudit décapage anisotrope sélectif.

6. Procédé selon la revendication 5, dans lequel la formation d'une bande (11) de dioxyde de silicium relativement épais (11) a lieu par oxydation sélective à haute température à l'aide d'un masque de nitrure de silicium.
